Europäisches Patentamt

(19) European Patent Office  (11) Publication number: **0 148 027**

Office européen des brevets  **B1**

(12) **EUROPEAN PATENT SPECIFICATION**

(45) Date of publication of patent specification: **28.03.90**  (51) Int. Cl.⁵: **H 03 K 5/153**

(21) Application number: **84309095.2**

(22) Date of filing: **27.12.84**

(54) **Pulse generating circuit.**

(30) Priority: **27.12.83 JP 244533/83**

(43) Date of publication of application:
**10.07.85 Bulletin 85/28**

(45) Publication of the grant of the patent:
**28.03.90 Bulletin 90/13**

(84) Designated Contracting States:
**DE FR GB**

(56) References cited:
**EP-A-0 069 444**
**EP-A-0 083 482**
**US-A-3 575 608**
**US-A-4 591 744**

**U. TIETZE et al.: "Hableiter-Schaltungstechnik",
5th edition, 1980, pages 132,133,163,164,
Springer-Verlag, Berlin, DE**

**ELECTRON DEVICE LETTERS, vol. EDL-5, no. 4,
April 1984, pages 115-117, IEEE, New York, US;
S.J. LEE et al.: "Static random access memory
using high electron mobility transistors"**

(73) Proprietor: **FUJITSU LIMITED**
**1015, Kamikodanaka Nakahara-ku
Kawasaki-shi Kanagawa 211 (JP)**

(72) Inventor: **Itoh, Hideo
1726, Kamikodanaka Nakahara-ku
Kawasaki-shi Kanagawa 211 (JP)**
Inventor: **Koshizuka, Atuo
Seiwa-so 5 395, Shimokodanaka Nakahara-ku
Kawasaki-shi Kanagawa 211 (JP)**
Inventor: **Furumochi, Kazuto
13-13, Edakita 2-chome Midori-ku
Yokohama-shi Kanagawa 227 (JP)**

(74) Representative: **Fane, Christopher Robin King
et al
HASELTINE LAKE & CO. Hazlitt House 28
Southampton Buildings Chancery Lane
London, WC2A 1AT (GB)**

Courier Press, Leamington Spa, England.

## Description

The present invention relates to pulse generating circuitry, and in particular to circuitry for generating output pulses in response to logic level transitions in two input signals which are substantially complementary to one another.

Such pulse generating circuitry can be applied to an address transition detecting circuit in a semiconductor memory device and to other pulse circuits for providing accurate timing pulses generated in accordance with changes in two complementary signals.

In a semiconductor memory device such as a static-type random access memory (S-RAM), access time may be shortened by the provision of "short-circuit" transistors connected across respective pairs of complementary signal lines, for example across the bit lines of each bit line pair, between data bus lines, between the sense-amplifier (S/A) lines of each S/A line pair, and between the data-out buffer lines of each data-out buffer line pair. The transistors may be temporarily turned on in response to a clock pulse which is generated by a change in an input address signal when a readout of information is to be effected, so that the potential difference between bit lines or data bus lines of each pair rapidly becomes zero. The clock pulse may also be used for initializing a sense-amplifier and an output buffer.

To generate the clock pulse from changes in the address signals, an address transition detecting (ATD) circuit may be provided in the semiconductor memory device.

The reduction of the access time of the memory device depends on triggering the short-circuit transistors at the desired instant, so as to activate them for a predetermined time interval. Various pulse generating circuits for such an ATD circuit have been proposed, for providing the clock signal for triggering the transistors.

U.S. Patent No. 4,464,581, "Trigger Pulse Generator", issued on August 7, 1984, discloses one form of pulse generation circuit, but it is found that this may fail to generate trigger pulses when two complementary address signals applied as inputs to the pulse generation circuit undergo logic level transitions at significantly different times, and the output pulse width may vary in dependence upon difference in timing between the respective transitions in the two complementary address signals. The above disadvantages will be explained later in detail with reference to a specific circuit.

According to the present invention, there is provided a pulse generating circuitry comprising a bistable flip-flop circuit, of the type including first and second logic circuits and having set and reset terminals connected to respective first inputs of the first and second logic circuits, the first logic circuit having an output connected to the second input of the second logic circuit, and the second logic circuit having an output connected to a second input of the first logic circuit, and further comprising a third logic circuit having first and second inputs connected respectively to the outputs of the first and second logic circuits, the circuitry being such that a momentary coincidence of the logic level values at the respective outputs of the first and second logic circuits can be brought about by application to the said set and reset terminals of respective first and second input signals that are substantially complementary to one another, which coincidence causes an output pulse to be produced at the output of the said third logic circuit.

Reference will now be made, by way of example, to the accompany drawings, in which:

Figure 1 is a block diagram of an S-RAM device including an ATD circuit;

Figure 2 is a circuit diagram of an address buffer and a prior art pulse generating circuit suitable for use in the S-RAM device of Figure 1;

Figures 3A, 3B and 4A, 4B are timing diagrams illustrating operation of the pulse generating circuit of Figure 2;

Figures 5A, 5B are timing diagrams illustrating operation of a prior art pulse generating circuit when used in the device of Figure 1;

Figure 6 is a circuit diagram of pulse generating circuitry embodying the present invention;

Figure 7 is a detailed circuit diagram of one particular form of the circuitry of Figure 6;

Figures 8A to 10C are timing diagrams illustrating the operation of the circuit shown in Figure 7;

Figure 11 is a detailed circuit diagram of a second particular form of the circuitry of Figure 6; and

Figure 12 is a detailed circuit diagram of a third particular form of the circuitry of Figure 6.

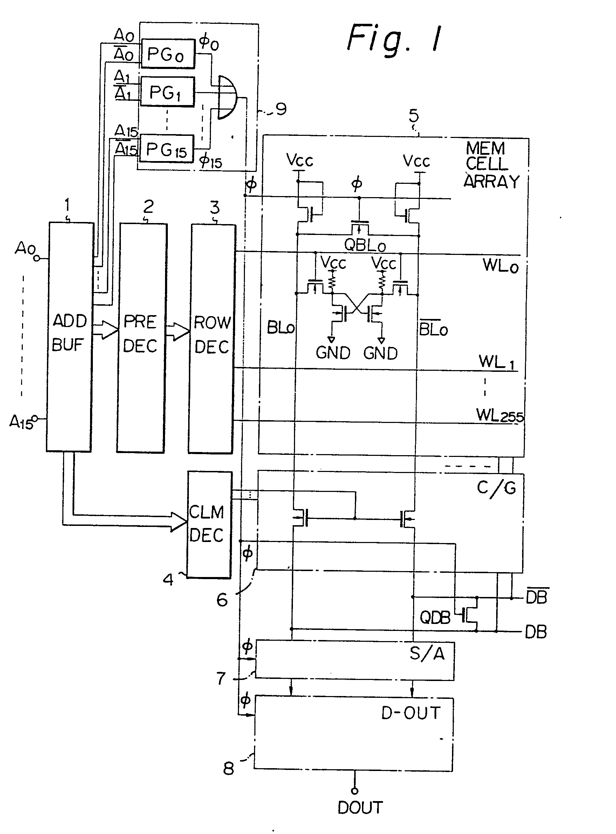

Figure 1 is a block diagram of an S-RAM device including an address buffer 1, a predecoder circuit 2, a row decoder circuit 3, a column decoder circuit 4, a memory cell array 5, a column gate portion 6, an S/A portion 7, and a data-out buffer portion 8. The memory cell array 5 includes a plurality of static memory cells each having connections to a word line (WL) and to a bit line pair comprising a bit line (BL) and an inverted bit line ($\overline{BL}$). The above components are similar to those of a conventional S-RAM device, accordingly, an explanation thereof will be omitted.

The S-RAM device further includes an ATD circuit 9 consisting of a plurality of pulse generating circuits (PG) each generating a clock pulse $\phi_i$ in response to respective changes in a pair of address bits $A_i$ and $\overline{A_i}$, and an OR gate having inputs connected to the respective outputs of the pulse generating circuits to provide, at an output of the circuit 9, a clock pulse $\phi$ whenever a clock pulse is generated by one of the plurality of pulse generating circuits. There is also provided a plurality of short-circuit transistors $QBL_0$ to $QBL_{255}$, each provided between a pair of bit lines BL and $\overline{BL}$ in the memory cell array 5; and a short-circuit transistor QDB provided between a pair of data bus lines comprising a data bus (DB) and an inverted data bus ($\overline{DB}$). The transistors mentioned above are turned on in response to the clock pulse $\phi$ from the ATD circuit 9.

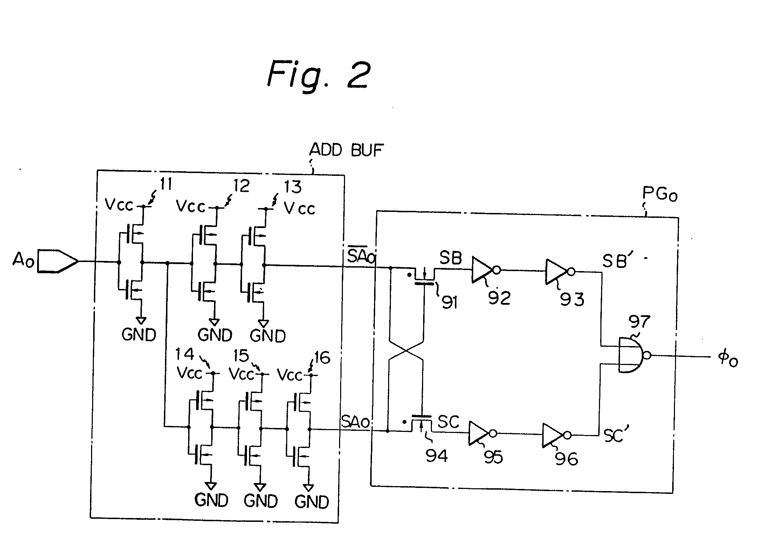

Figure 2 is a circuit diagram of the address buffer 1 and a pulse generating circuit in the ATD circuit 9. The address buffer 1 receives an address signal consisting of a plurality of address bits, for example 16 bits $A_0$ to $A_{15}$ for activating 256 word lines and 256 bit lines in a 64K bit S-RAM device, and outputs a plurality of pairs of address bit signals, each pair consisting of a non-inverted and an inverted address bit signal. Figure 2 shows one address buffer for an input address bit $A_0$ providing inverted and non-inverted output address bit signals $\overline{SA_0}$ and $SA_0$. The address buffer includes a common inverter 11, two tandem inverters 12 and 13, and three tandem inverters 14 to 16, each inverter being formed as a complementary metal oxide semiconductor (C-MOS) inverter.

The pulse generating circuit in the ATD circuit 9 is substantially identical to that disclosed in U.S. Patent No. 4,464,581. The pulse generating circuit consists of depletion-type metal insulated semiconductor (MIS) field effect transistors (FET's) 91 and 94, inverters 92, 93, 95, and 96, and a NOR gate 97 connected as shown in Figure 2.

The operation of the address buffer and the pulse generating circuit shown in Figure 2 will be explained below in detail. When the input signal $A_0$ at the address buffer 1 changes from high level to low level, the non-inverted output signal $SA_0$ rapidly changes from high level to low level and the inverted output signal $\overline{SA_0}$ rapidly changes from low level to high level. When the pulse generating circuit receives both signals $SA_0$ and $\overline{SA_0}$, the gate-source potential of the transistor 94 rises and the gate-source potential of the transistor 91 falls, so that the input signal $SA_0$ of the pulse generating circuit is transferred to the inverter 95 through the transistor 94 which is in a state of high mutual conductance $g_m$ (or high conductivity). In this case, electric charges in the stray capacitance at the input of the inverter 95 are quickly discharged. On the other hand, the input signal $\overline{SA_0}$ is gradually transferred to the inverter 92 through the transistor 91 which is in a state of low mutual conductance $g_m$. The stray capacitance at the input of the inverter 92 is gradually charged with a time constant defined by the stray capacitance and the resistance of the transistor 91. As a result, the input signal SC applied to the inverter 95 falls rapidly and the input signal SB applied to the inverter 92 rises gradually.

After a short period elapses, when the input signal $A_0$ at the address buffer 1 rises from low level to high level, the input signal SC to the inverter 95 rises slowly and the input signal SB to the inverter 92 falls quickly.

Two pairs of series-connected inverters 92, 93 and 95, 96 perform wave-shaping of the input signals SB and SC, respectively. Wave-shaped signals SB' and SC' are supplied to the NOR gate 97, so that clock pulses $\phi_0$ synchronized with the falling (or trailing) and rising edges of the input signal A are generated, which pulses should of a predetermined width.

The pulse width $P_w$ of each output clock pulse

$\phi_0$ is substantially defined by the respective mutual conductances $g_m$ of the transistors 91 and 94, the threshold potentials $V_{th}$ of the inverters 92 and 95, and the stray capacitance at the inputs of the inverters 92 and 95.

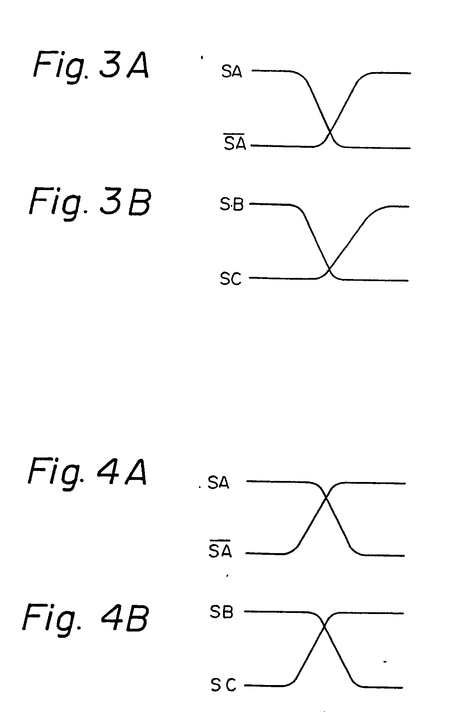

In the above description, it is assumed that the two signals $SA_0$ and $\overline{SA_0}$ undergo complementary changes in level at the sametime. It should be noted that, in the address buffer shown in Figure 2, the inverted signal $\overline{SA_0}$ is generated through three series inverters 11, 12, and 13, whereas the non-inverted signal $SA_0$ is generated through four series inverters 11, 14, 15 and 16. Assuming that the propagation delay through each of these inverters is the same, there is an inherent time delay between the signals $SA_0$ and $\overline{SA_0}$ due to the different numbers of inverters in their respective signal propagation paths. As a result, whether the circuit 1 is configured such that the signal $SA_0$ has the longer propagation path or the signal $\overline{SA_0}$ has the longer path, there is a time lag between the respective transitions in the signals $SA_0$ and $\overline{SA_0}$, as shown in Figures 3A and 4A, so that the output signals SB and SC in the pulse generating circuit differ in transition timing. This may cause the pulse width $P_w$ of the clock pulse $\phi$ to differ from its intended value.

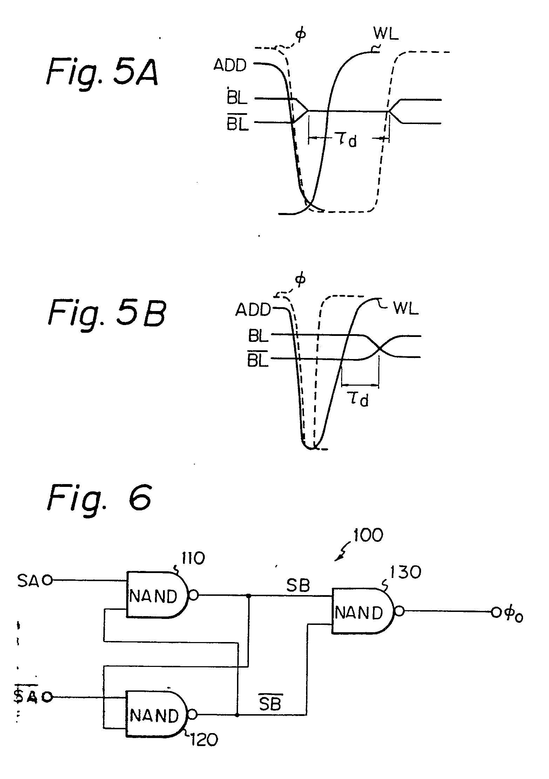

Variations in the pulse width $P_w$ of the clock pulse $\phi$ can adversely affect the access time, as illustrated in Figures 5A and 5B. Figures 5A and 5B show curves of the instantaneous values of the clock pulse $\phi$, the word line signal WL, the address signal ADD, and the pair of bit lines BL and $\overline{BL}$. In Figure 5A, a longer width clock pulse $\phi$ is shown to result in an idle time $\tau d$. In Figure 5B, a shorter width clock pulse $\phi$ is shown to result in a shorter idle time $\tau d'$.

In an extreme case, a very large time lag between the respective transitions of the signals $SA_0$ and $\overline{SA_0}$ could cause the pulse generating circuit 9 to completely fail to produce any clock pulses.

In order to overcome the disadvantages mentioned above, in the prior art circuit the address buffer 1 shown in Figure 2 must be constructed so that the two complementary output signals SA and $\overline{SA}$ change in level at precisely the same time. This, however, involves a difficult device design and a strict manufacturing process.

Figure 6 is a circuit diagram of an embodiment of a pulse generating circuit in accordance with the present invention.

The pulse generating circuit 100 in Figure 6 consists of three NAND gates 110, 120, 130. As shown in Figure 6, a first input signal SA and an output signal $\overline{SB}$ of a second NAND gate 120 are applied to inputs of a first NAND gate 110, a second input signal $\overline{SA}$ and an output signal SB of the first NAND gate 110 to inputs of the second NAND gate 120, and the output signals SB and $\overline{SB}$ to inputs of a third NAND gate 130. The third NAND gate 130 outputs a pulse $\phi$. The pulse generating circuit 100 can be applied to the ATD circuit 9 in Figure 1 in place of the circuit of Figure 2 mentioned above.

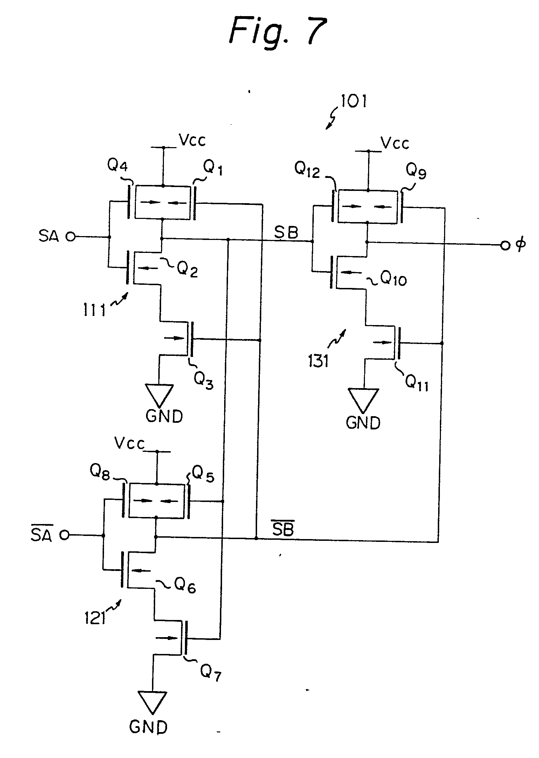

Figure 7 is a detailed circuit diagram of the circuit shown in Figure 6.

The pulse generating circuit 101 shown in Figure 7 is realized by using a plurality of C-MOS type inverters. A first NAND circuit 111 corresponding to the NAND circuit in Figure 6 is formed by two p-channel enhancement (p-E) type MOS transistors $Q_1$ and $Q_4$ connected in parallel and two n-channel enhancement (n-E) type MOS transistors $Q_2$ and $Q_3$ connected in series. Similarly, a second NAND circuit 121 corresponding to the NAND circuit 120 in Figure 6 is formed by two p-E type MOS transistors $Q_5$ and $Q_8$ and two n-E type MOS transistors $Q_6$ and $Q_7$. A third NAND circuit 131 corresponding to the NAND circuit 130 in Figure 6 is also formed by two p-E type MOS transistors $Q_9$ and $Q_{12}$ and two n-E type MOS transistors $Q_{10}$ and $Q_{11}$. Reference Vcc indicates a direct current (DC) power supply of 5V and GND a ground level.

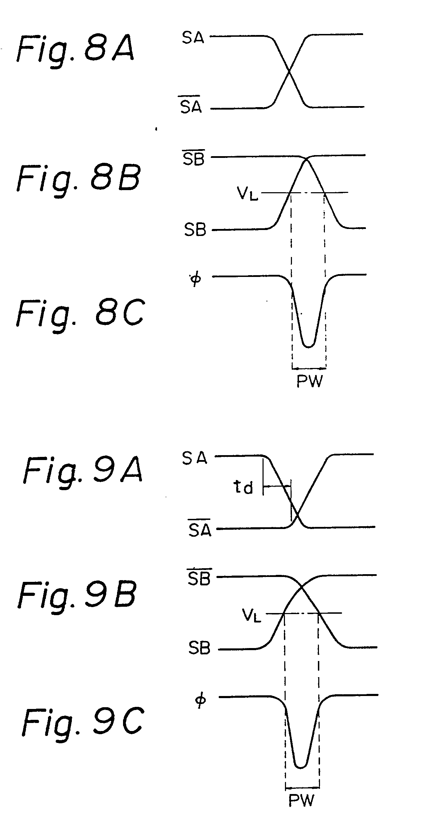

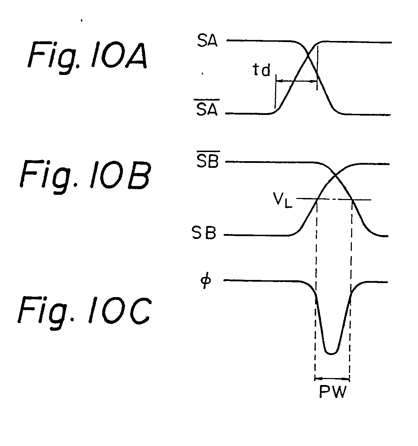

The operation of the pulse generating circuit 101 shown in Figure 7 will be explained with reference to Figures 8A, 8B, 8C to 10A, 10B, 10C.

First, the operation of the pulse generating circuit 101 will be explained in the case of two complementary input signals SA and $\overline{SA}$ having symmetrically changing waveforms, as shown in Figure 8A.

In the initial condition, the input signal SA is high level and the input signal $\overline{SA}$ is thus low level, whereby the transistors $Q_2$ and $Q_3$ in the NAND circuit 111 and the transistors $Q_5$ and $Q_8$ in the NAND circuit 121 are turned on and the transistors $Q_1$ and $Q_4$ in the NAND circuit 111 and the transistors $Q_6$ and $Q_7$ in the NAND circuit 121 are turned off. As a result, the output signal SB of the NAND circuit 111 is low level, and the output signal $\overline{SB}$ of the NAND circuit 121 is high level. Receiving the signals SB and $\overline{SB}$ in the gate circuit 131, the transistors $Q_{11}$ and $Q_{12}$ are turned on and the transistors $Q_9$ and $Q_{10}$ are turned off, and accordingly the output pulse φ is high level, as shown in Figure 8C.

As the input signal SA begins to fall to low level as shown in Figure 8A, the conductivity (or the mutual conductance $g_m$) of the transistor $Q_4$ becomes high and the conductivity of the transistor $Q_2$ becomes low. The resultant signal SB begins to rise as shown in Figure 8B. Symmetrically, the input signal $\overline{SA}$ begins to rise to high level. In the NAND circuit 121, even if the transistor $Q_8$ begins to turn off and the transistor $Q_6$ begins to turn on, the output signal $\overline{SB}$ of the NAND circuit 121 is still maintained at the high level until the transistor $Q_5$ is turned off and the transistor $Q_7$ is turned on. In this manner, the output signal $\overline{SB}$ only begins to fall when the output signal SB of the NAND circuit 111 becomes fully high level. In this transient condition, the waveforms of the otput signals SB and $\overline{SB}$ are represented as shown in Figure 8B, i.e. because of the inherent switching delay of the NAND circuit 121 there exists a period when both output signals SB and $\overline{SB}$ are higher than a predetermined level $V_L$. During this period, the signals SB

and $\overline{SB}$ are applied to gates of the transistors $Q_{12}$ and $Q_{10}$ and to gates of the transistors $Q_9$ and $Q_{11}$ in the NAND circuit 131, the transistors $Q_{10}$ and $Q_{11}$ are turned on, and the transistors $Q_9$ and $Q_{12}$ are turned off. As a result, at the output of the NAND circuit 131 a clock pulse φ having a predetermined pulse width $P_w$ corresponding to the above period is obtained at each change in the input signals SA and $\overline{SA}$.

Next, operation of the pulse generating circuit 101 shown in Figure 7 will be explained for the case in which the rising edge of the input signal $\overline{SA}$ is delayed with respect to the falling edge of the input signal SA by a time td, as shown in Figure 9A.

The output signal SB of the NAND circuit 111 begins to rise in response to the falling of the input signal SA. On the other hand, the output signal $\overline{SB}$ is maintained at the high level until the level of the output signal SB rises above the level $V_L$, as shown in Figure 9B, because the transistor $Q_7$ is not turned on. When the logic level of the output signal SB reaches the level $V_L$, the transistor $Q_7$ is turned on. As a result, the output signal $\overline{SB}$ falls to the low level. In this case, there is again a period when both output signals SB and $\overline{SB}$ are higher than the level $V_L$, as shown in Figure 9B. Accordingly, the NAND circuit 131 outputs the clock pulse φ having a pulse width $P_w$ equal to that of the pulse shown in Figure 8C.

Next, the operation of the pulse generating circuit 101 shown in Figure 7 will be explained with reference to Figures 10A to 10C for the case in which the falling edge of the input signal SA is delayed with respect to the rising edge of the input signal $\overline{SA}$ by the time td mentioned above.

When the input signal $\overline{SA}$ rises to high level, the transistor $Q_6$ is turned on and the transistor $Q_8$ is turned off. On the other hand, the output signal $\overline{SB}$ is still maintained at the high level until the output signal SB rises higher than the level $V_L$, because while the output signal SB remains at the low level the transistor $Q_5$ is still turned on and the transistor $Q_7$ is also still turned off. As the input signal SA falls, the transistor $Q_4$ is turned on and the transistor $Q_2$ is turned off, whereby the output signal SB falls. In response to the above operation, the transistor $Q_5$ is turned off and the transistor $Q_7$ is turned on. As a result, the output signal $\overline{SB}$ begins to fall as shown in Figure 10B. The output signals SB and $\overline{SB}$ vary as shown in Figure 10B. The NAND circuit 131 thus outputs the clock pulse φ having a pulse width $P_w$ equal to that shown in Figure 8C.

As mentioned above, the pulse generating circuit 101 shown in Figure 7 can detect the change of the input signals SA and $\overline{SA}$ and can reliably provide a clock pulse φ of constant pulse width in response to the change of both complementary signals SA and $\overline{SA}$, not only when the signals SA and $\overline{SA}$ are changed absolutely simultaneously, but also when their respective changes do not occur simultaneously.

In the above description, the second NAND circuit 120 is controlled by the output signal SB of the first NAND circuit 110 when the input signal SA is high level and the input signal $\overline{SA}$ is low level in the initial condition. On the other hand, the first NAND circuit 110 is controlled by the output signal $\overline{SB}$ of the second NAND circuit 120 when the input signal SA is low level and the input signal $\overline{SA}$ is high level in the initial condition.

Generally speaking, the pulse generating circuit 100 shown in Figure 6 is designed to operate in the following manner:

that one of the NAND circuits 110 and 120 which is connected to receive that one of the input signals SA or $\overline{SA}$ undergoing a change from a high logic level to a low logic level switches first in response to that change so that the signal logic level at its output becomes high, i.e. the signal voltage level becomes higher than a predetermined level. This causes, a predetermined time interval later, the switching of the other of the NAND circuits 110 or 120, whereby a momentary coincidence in the logic levels at the outputs of the two NAND circuits is brought about (i.e. the two output signals from the first and second NAND circuits are both higher than the predetermined level), and a pulse having a predetermined pulse width is produced by the third NAND circuit 130.

Other embodiments of the circuit 100 shown in Figure 6 are possible in addition to the C-MOS NAND circuit 101 shown in Figure 7.

Incidentally, it will be appreciated that the first and second NAND circuits of Figure 6 are connected to form a bistable flip-flop circuit of the type shown, for example, in "Halbleiter-Schaltungstechnik" (Fifth revised edition), U. Tietze & Ch. Schenk, Springer-Verlag 1980, in Figure 9.38 on page 163.

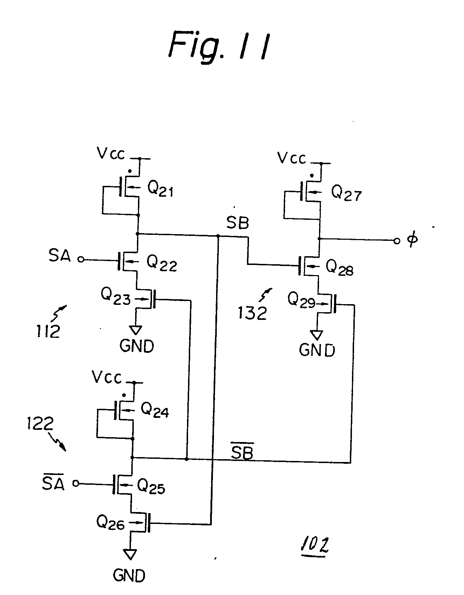

Figure 11 is a circuit of another embodiment formed as an n-channel (N-)MOS NAND circuit. The pulse generating circuit 102 consists of three NAND circuits 112, 122, and 132. The NAND circuit 112 includes an n-channel depletion (n-D) transistor $Q_{21}$ and two n-channel enhancement (n-E) transistors $Q_{22}$ and $Q_{23}$; the NAND circuit 122 an n-D transistor $Q_{24}$ and two n-E transistors $Q_{25}$ and $Q_{26}$; and the NAND circuit 132 an n-D transistor $Q_{27}$ and two n-E transistors $Q_{28}$ and $Q_{29}$.

The operations fo the pulse generating circuit 102 is similar to the operation of the circuit 101 shown in Figure 7.

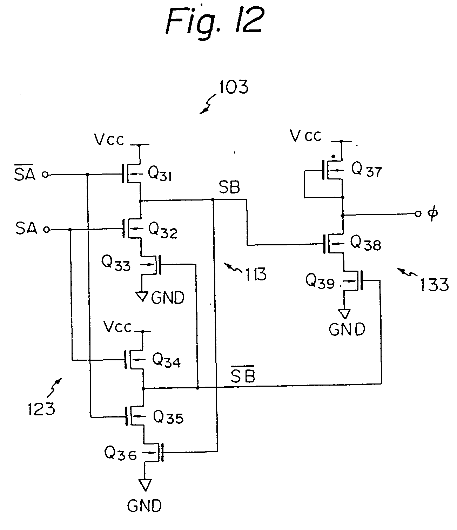

Figure 12 is a circuit of yet another embodiment of the circuit shown in Figure 6, formed by N-MOS NAND circuit. The pulse generating circuit 103 consists of three NAND circuits 113, 123, and 133. The circuits 113 and 123 are respectively formed by three n-E transistors $Q_{31}$ to $Q_{33}$ and $Q_{34}$ to $Q_{36}$. The third NAND circuit 133 is formed by an n-D transistor $Q_{37}$ and two n-E transistors $Q_{38}$ and $Q_{39}$.

The first logic circuit 113 has three input signals: i.e., the input signal $\overline{SA}$ to a gate of the transistor $Q_{31}$, the input signal SA to a gate of the transistor $Q_{31}$, and the input signal $\overline{SB}$ from the second logic circuit 123. Similarly, the second logic circuit 123 has three input signals. In the circuits shown in Figures 7 and 11, the first and second logic circuits had only two input signals. This distinction between the circuit shown in Figure 12 and others mentioned above, however, is not significant operationally, the main parts of the first and second logic circuits 113 and 123 shown in Figure 12 being the transistors $Q_{32}$ and $Q_{33}$ and the transistors $Q_{35}$ and $Q_{36}$, so that the first and second logic circuits 113 and 123 substantially function as two-input NAND circuits.

Accordingly, operation of the pulse generating circuit 103 is similar to that of circuit 101 shown in Figure 7.

Use of pulse generating circuits embodying the present invention in the ATD circuit 9 shown in Figure 1 can enable a desirably short access time to be achieved with more certainty because the generated clock pulse widths are not dependent upon the relative timings of the transitions of the input signals $SA_0$ and $\overline{SA_0}$ of Figure 2.

In addition, such a pulse generating circuit may be applied to other circuits, for example, the row and column address decoders 3 and 4 in Figure 1, which receive an address signal consisting of a plurality of pairs of address bits composed of two complementary signals.

Embodiments of the present invention can be realized with logic circuits other than the NAND logic circuits mentioned above, for example by NOR logic circuits, and/or by circuit technologies other than the MOS circuit technology, for example by MIS circuit technology.

Pulse generating circuits embodying the present invention can be applied to other systems, for example, asynchronous-type memory systems, such as a mask-ROM device and an erasable programmable ROM (EPROM) device. In these devices, there are no bit line pairs and each data line forms a single line, but output pulses from a pulse generating circuit embodying the present invention can be used, for example, to reset a data-out buffer and word lines to improve the access time.

**Claims**

1. Pulse generating circuitry comprising a bistable flip-flop circuit, of the type including first and second logic circuits and having set and reset terminals connected to respective first inputs of the first and second logic circuits (110, 120), the first logic circuit having an output (SB) connected to a second input of the second logic circuit, and the second logic circuit having an output ($\overline{SB}$) connected to a second input of the first logic circuit, and further comprising a third logic circuit (130) having first and second inputs connected respectively to the outputs of the first and second logic circuits, the circuitry being such that a momentary coincidence of the logic level values at the respective outputs of the first and second logic circuits can be brought about by application to the said set and reset terminals of respective first and second input signals (SA, $\overline{SA}$) that are substantially complementary to one another, which coincidence causes an output pulse to be produced at the output of the said third logic circuit.

2. Pulse generating circuitry as claimed in Claim 1, wherein the said set and reset terminals are connected to a circuit operable to apply thereto such respective input signals (SA, $\overline{SA}$).

3. Pulse generating circuitry as claimed in Claim 1 or 2, such that if the respective signal logic levels at the outputs (SB, $\overline{SB}$) of the said first and second logic circuits are low and high respectively, then when the said first input signal (SA), applied to the said set terminal, changes from a high to a low logic level, the said signal logic level at the output (SB) of the first logic circuit is thereby caused to change to a high logic level a predetermined time interval before the signal logic level at the output ($\overline{SB}$) of the second logic circuit is caused to change to a low logic level, whereby the said momentary coincidence of the logic level values at those outputs is produced and an output pulse is generated at the output of the said third logic circuit, and such that if the respective signal logic levels at the outputs of the said first and second logic circuits are high and low respectively, then when the said second input signal ($\overline{SA}$), applied to the said reset terminal, changes from a high to a low logic level, the said signal logic level at the output ($\overline{SB}$) of the second logic circuit is thereby caused to change to a high logic level a predetermined time interval before the signal logic level at the output (SB) of the first logic circuit is caused to change to a low logic level, whereby the said momentary coincidence of the logic level values at those outputs is produced and an output pulse is generated at the output of the said third logic circuit.

4. Pulse generating circuitry as claimed in Claim 1 or 2, wherein each of the said first, second and third logic circuits is a NAND circuit.

5. Pulse generating circuitry as claimed in any preceding claim, wherein each of the said logic circuits is a CMOS circuit.

6. Pulse generating circuitry as claimed in Claim 5, wherein each of the said logic circuits is made up of enhancement-type transistors.

7. Pulse generating circuitry as claimed in any one of Claims 1 to 4, wherein each of the said logic circuits is an NMOS circuit.

8. Pulse generating circuitry as claimed in Claim 7, wherein each of the said logic circuits is made up of a depletion-type transistor in series with a first enhancement-type transistor in series with a second enhancement-type transistor.

9. Pulse generating circuit as claimed in Claim 7, wherein each of the said first and second logic circuits is made up of three enhancement-type transistors connected in series with one another, and the said third logic circuit is made up of a depletion-type transistor in series with a first enhancement-type transistor in series with a second enhancement-type transistor, the said first and second logic circuits having respective third inputs connected respectively to the said reset and set terminals.

10. Pulse generating circuitry as claimed in Claim 1 or 2, wherein each of the said first, second and third logic circuits is a NOR circuit.

**Patentansprüche**

1. Impulsgeneratorschaltung mit einer bistabilen Flipflop-Schaltung von dem Typ, der erste und zweite Logikschaltungen enthält und Setz- und Rücksetzanschlüsse hat, die mit entsprechenden ersten Eingängen der ersten und zweiten Logikschaltungen (110, 120) verbunden sind, wobei die erste Logikschaltung einen Ausgang (SB) hat, der mit einem zweiten Eingang der zweiten Logikschaltung verbunden ist, und die zweite Logikschaltung einen Ausgang ($\overline{SB}$) hat, der mit einem zweiten Eingang der ersten Logikschaltung verbunden ist, und ferner mit einer dritten Logikschaltung (130), die erste und zweite Eingänge hat, die mit den Ausgängen der ersten bzw. zweiten Logikschaltung verbunbden sind, wobei die Schaltung so ist, daß eine momentane Koinzidenz der Logikpegelwerte an den entsprechenden Ausgängen der ersten und zweiten Logikschaltungen durch Anwendung der ersten bzw. zweiten Eingangssignale (SA, $\overline{SA}$), die im wesentlichen komplementär zueinander sind, zu den genannten Satz- und Rücksetzanschlüssen herbeigeführt werden kann, welche Koinzidenz bewirkt, daß an dem Ausgang der genannten dritten Logikschaltung ein Ausgangsimpuls erzeugt wird.

2. Impulsgeneratorschaltung nach Anspruch 1, bei der die genannten Setz- und Rücksetzanschlüsse mit einer Schaltung verbunden sind, die betreibbar ist, um ihnen solche entsprechenden Eingangssignale (SA, $\overline{SA}$) zuzuführen.

3. Impulsgeneratorschaltung nach Anspruch 1 oder 2, derart, daß, falls die entsprechenden Logiksignalpegel an den Ausgängen (SB, $\overline{SB}$) der ersten und zweiten Logikschaltung niedrig bzw. hoch sind, dann, wenn das genannte erste Eingangssignal (SA), das dem genannten Setzanschluß zugeführt wird, sich von einem hohen zu einem niederen Logikpegel ändert, der genannte Signallogikpegel an dem Ausgang (SB) der ersten Logikschaltung dadurch zu einem hohen Logikpegel geändert wird, ein vorbestimmtes Zeitintervall bevor der Signallogikpegel an dem Ausgang ($\overline{SB}$) der zweiten Logikschaltung zu einem niedrigen Logikpegel geändert wird, wodurch die genannte momentane Koinzidenz der Logikpegelwerte an jenen Ausgängen erzeugt wird und eine Ausgangsimpuls an dem Ausgang der genannten dritten Logikschaltung erzeugt wird, und derart, daß, falls die entsprechenden Signallogikpegel an den Ausgängen der genannten ersten und zweiten Logikschaltungen hoch bzw. niedrig sind, dann, wenn das genannte zweite Eingangssignal ($\overline{SA}$), das dem genannten Rücksetzanschluß zugeführt wird, von einem hohen zu einem niedrigen Logikpegel wechselt, der genannte Signallogikpegel an dem Ausgang ($\overline{SB}$) der zweiten Logikschaltung dadurch zu einem hohen Logikpegel geändert wird, ein vorbestimmtes Zeitintervall bevor der Signallogikpegel an dem Ausgang (SB) der ersten Logikschaltung zu einem niedrigen Logikpegel geändert wird, wodurch die genannte momentane Koinzidenz der Logikpegelwerte an jenen Ausgängen erzeugt wird und ein Ausgangsimpuls an dem Ausgang der genannten dritten Logikschaltung erzeugt wird.

4. Impulsgeneratorschaltung nach Anspruch 1 oder 2, bei der jede der ersten, zweiten und dritten Logikschaltungen eine NAND-Schaltung ist.

5. Impulsgeneratorschaltung nach einem der vorhergehenden Ansprüche, bei der jede der genannten Logikschaltungen eine CMOS-Schaltung ist.

6. Impulsgeneratorschaltung nach Anspruch 5, bei der jede der genannten Logikschaltungen aus Transistoren vom Anreicherungstyp besteht.

7. Impulsgeneratorschaltung nach einem der Ansprüche 1 bis 4, bei der jede der genannten Logikschaltungen eine NMOS-Schaltung ist.

8. Impulsgeneratorschaltung nach Anspruch 7, bei der jede der genannten Logikschaltungen aus einem Verarmungstyp-Transistor in Reihe mit einem ersten Anreicherungstyp-Transistor in Reihe mit einem zweiten Anreicherungstyp-Transistor besteht.

9. Impulsgeneratorschaltung nach Anspruch 7, bei der jede der genannten ersten und zweiten Logikschaltungen aus drei Anreicherungstyp-Transistoren besteht, die in Reihe miteinander verbunden sind, und die genannte dritte Logikschaltung aus einem Verarmungstyp-Transistor in Reihe mit einem ersten Anreicherungstyp-Transistor in Reihe mit einem zweiten Anreicherungstyp-Transistor besteht, wobei die ersten und zweiten Logikschaltungen jeweils dritte Eingänge haben, die jeweils mit den Rücksetz- bzw. Setzanschlüssen verbunden sind.

10. Impulsgeneratorschaltung nach Anspruch 1 oder 2, bei der jede der genannten ersten, zweiten oder dritten Logikschaltungen eine NOR-Schaltung ist.

**Revendications**

1. Circuits générateurs d'impulsions comprenant un circuit à bascule bistable du type incluant des premier et deuxième circuits logiques et ayant des bornes de postionnement et de remise à l'état initial connectées à des première entrées respectives des premier et deuxième circuits logiques (110, 120), le premier circuit logique ayant une sortie (SB) connectée à une deuxième entrée du deuxième circuit logique, et le deuxième circuit logique ayant une sortie ($\overline{SB}$) connectée à une deuxième entrée du premier circuit logique, et comprenant en outre un troisième circuit logique (130) ayant des première et deuxième entrées connectées respectivement aux sorties des premier et deuxième circuits logiques, les circuits étant tels qu'une coïncidence momentanée des valeurs de niveau logique aux sorties respectives des premier et deuxième circuits logiques peut être provoquée par application aux bornes de positionnement et de remise à l'état initial des premier et deuxième signaux d'entrée respectifs (SA, $\overline{SA}$) qui sont essentiellement complémentaires entre eux, cette coïncidence faisant en sorte qu'une impulsion de sortie est produite à la sortie du troisième circuit logique.

2. Circuits générateurs d'impulsions selon la revendication 1, dans lesquels les bornes de positionnement et de remise à l'état initial sont connectées à un circuit pouvant être mis en fonctionnement pour leur appliquer ces signaux d'entrée respectifs (SA, $\overline{SA}$).

3. Circuits générateurs d'impulsions selon l'une quelconque des revendications 1 et 2, tels que si les niveaux logiques de signaux respectifs aux sorties (SB, $\overline{SB}$) des premier et deuxième circuits logiques sont respectivement bas et haut, quand le premier signal d'entrée (SA) appliqué à la borne de positionnement passe d'un niveau logique haut à un niveau logique bas, le niveau logique de signal à la sortie (SB) du premier circuit logique est alors ainsi mis à un niveau logique haut un intervalle de temps prédéterminé avant que le niveau logique de signal à la sortie ($\overline{SB}$) du deuxième circuit logique soit mis à un niveau logique bas, la coïncidence momentanée des valeurs de niveau logique à ces sorties étant ainsi produite et une impulsion de sortie est engendrée à la sortie du troisième circuit logique, et tels que si les niveaux logiques des signaux respectifs aux sorties des premier et deuxième circuits logiques sont respectivement haut et bas, quand le deuxième signal d'entrée ($\overline{SA}$) appliqué à la borne de remise à l'état initial passe d'un niveau logique haut à un niveau logique bas, le niveau logique de signal à la sortie ($\overline{SB}$) du deuxième circuit logique est alors ainsi mis à un niveau logique haut un intervalle de temps prédéterminé avant que le niveau logique de signal à la sortie (SB) du premier circuit logique soit mis à un niveau logique bas, la coïncidence momentanée des valeurs de niveau logique à ces sorties étant ainsi produite et une impulsion de sortie est engendrée à la sortie du troisième circuit logique.

4. Circuits générateurs d'impulsions selon l'une quelconque des revendications 1 et 2, dans lesquels chacun des premier, deuxième et troisième circuits logiques est un circuit NON-ET.

5. Circuits générateurs d'impulsions selon l'une quelconque des revendications 1 à 4, dans lesquels chacun des circuits logiques est un circuit à métal-oxyde-semiconducteur à symétrie complémentaire C-MOS.

6. Circuits générateurs d'impulsions selon la revendication 5, dans lesquels chacun des circuits logiques est constitué de transistors du type à enrichissement.

7. Circuits générateurs d'impulsions selon l'une quelconque des revendications 1 à 4, dans lesquels chacun des circuits logiques est un circuit à métal-oxyde-semiconducteur à canal N (NMOS).

8. Circuits générateurs d'impulsions selon la revendication 7, dans lesquels chacun des circuits logiques est constitué d'un transistor du type à épuisement en série avec un premier transistor du type à enrichissement en série avec un deuxième transistor du type à enrichissement.

9. Circuits générateurs d'impulsions selon la revendication 7, dans lesquels chacun des premier et deuxième circuits logiques est constitué de trois transistors du type à enrichissement connectés en série entre eux, et le troisième circuit logique est constitué d'un transistor du type à épuisement en série avec un premier transistor du type à enrichissement en série avec un deuxième transistor du type à enrichissement, les premier et deuxième circuits logiques ayant des troisièmes entrées respectives connectées respectivement aux bornes de remise à l'état initial et de positionnement.

10. Circuits générateurs d'impulsions selon l'une quelconque des revendications 1 et 2, dans lesquels chacun des premier, deuxième et troisième circuits logiques est un circuit NI.

*Fig. 1*

# Fig. 2

*Fig. 3 A*

SA

$\overline{SA}$

*Fig. 3 B*

S·B

SC

*Fig. 4 A*

. SA

$\overline{SA}$

*Fig. 4 B*

SB

S C

*Fig. 5A*

*Fig. 5B*

*Fig. 6*

# Fig. 7

*Fig. 8A*

SA

$\overline{SA}$

*Fig. 8B*

$\overline{SB}$

$V_L$

SB

*Fig. 8C*

φ

PW

*Fig. 9A*

SA

td

$\overline{SA}$

*Fig. 9B*

$\overline{SB}$

$V_L$

SB

*Fig. 9C*

φ

PW

Fig. IOA

Fig. IOB

Fig. IOC

# Fig. 11

# Fig. 12